Europäisches Patentamt

European Patent Office

Office européen des brevets

(19)

(11) EP 0 363 163 B1

(12) EUROPEAN PATENT SPECIFICATION

(45) Date of publication and mention
of the grant of the patent:
**24.07.1996 Bulletin 1996/30**

(51) Int Cl.6: **G03F 7/20**

(21) Application number: **89310127.9**

(22) Date of filing: **04.10.1989**

(54) **X-ray exposure apparatus**

Röntgenstrahl-Belichtungsvorrichtung

Appareil pour l'exposition aux rayons X

(84) Designated Contracting States:
**DE FR GB NL**

(30) Priority: **05.10.1988 JP 249902/88**

(43) Date of publication of application:
**11.04.1990 Bulletin 1990/15**

(73) Proprietor: **CANON KABUSHIKI KAISHA
Tokyo 146 (JP)**

(72) Inventors:
 • **Tanaka, Yutaka
 Yokohama-shi Kanagawa-ken (JP)**
 • **Mizusawa, Nobutoshi
 Yamato-shi Kanagawa-ken (JP)**
 • **Amemiya, Mitsuaki
 Atsugi-shi Kanagawa-ken (JP)**
 • **Kariya, Takao
 Hino-shi Tokyo (JP)**
 • **Shimoda, Isamu
 Zama-shi Kanagawa-ken (JP)**

(74) Representative:
**Beresford, Keith Denis Lewis et al
BERESFORD & Co.
2-5 Warwick Court
High Holborn
London WC1R 5DJ (GB)**

(56) References cited:
**EP-A- 0 178 660          GB-A- 2 155 201**

## Description

This invention relates to an X-ray exposure apparatus for lithographically transferring onto a semiconductor wafer a fine pattern of semiconductor integrated circuit, by using soft X-rays.

As a light source of such an X-ray exposure apparatus, there are a bulb type one which produces X-rays by electron beam excitation, one which uses X-rays produced from plasma, one that uses synchrotron orbit radiation, and the like. All of these X-ray sources produce X-rays in vacuum. Accordingly, usually an X-ray source is disposed in a vacuum and gas-tight X-ray source accommodating chamber, and produced X-rays is projected to a mask or wafer through a blocking window made of a material (usually, beryllium (Be)) having high X-ray transmission factor.

If in this case atmosphere is present in the path of X-ray transmission from the blocking window to a wafer, X-rays are absorbed by the atmosphere, resulting in an increase in exposure time and thus in a decrease of the throughput. Considering an X-ray exposure apparatus as an industrial productive machine, the decrease in throughput is a critical problem. In an attempt to solving this, a proposal has been made, in accordance with which an alignment mechanism for a mask and a wafer is disposed in a vacuum and gas-tight container chamber (hereinafter "stage accommodating chamber") and such stage accommodating chamber is filled with a particular gaseous fluid (usually, helium (He) gas) of reduced pressure, lower than the atmospheric pressure, having small X-ray absorbency.

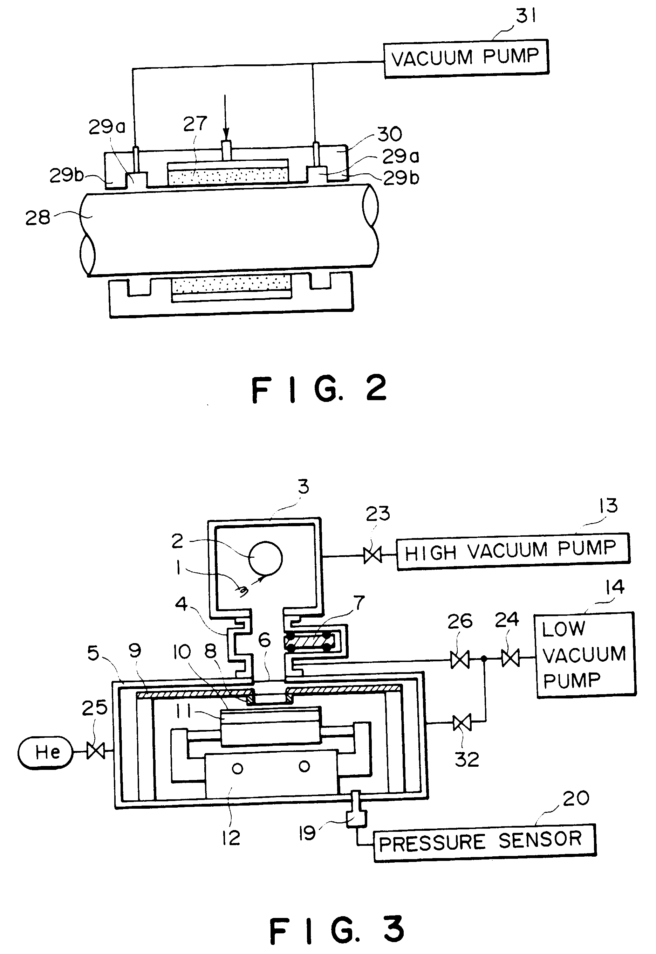

Figure 3 shows the structure of a known type X-ray exposure apparatus.

In Figure 3, X-ray source comprising an electron gun 1 and a target 2, is sealingly kept in an X-ray source accommodating chamber 3. The X-ray source accommodating chamber 3 is coupled to a high vacuum pump 13 by way of a valve 23, and the inside of the chamber is maintained at high vacuum not greater than $10^{-4}$ [Pa]($10^{-6}$[Torr]). Barrel 4 is connected to the X-ray source accommodating chamber 3, which barrel is equipped with a gate valve 7. Mask 8 and wafer 10 which are the objects to be irradiated with X-rays, are accommodated in a stage accommodating chamber 5, together with a wafer stage 12. Denoted at 9 is a mask chuck, and at 11 is a wafer chuck.

The stage accommodating chamber 5 is provided with a beryllium blocking window 6 and, to this chamber the barrel 4 is connected. By way of valves 32 and 24, a low vacuum pump 14 is coupled to the stage accommodating chamber 5. Also, by way of a valve 25, helium can be supplied thereinto. Denoted at 26 is a by-pass valve, and at 20 is a pressure sensor.

As a guide mechanism for the wafer stage 12 which is accommodated in the stage accommodating chamber 5, a static pressure bearing means which is usable even in vacuum is used.

In this example of known type X-ray exposure apparatus, first the stage accommodating chamber 5 is vacuum-evacuated to a predetermined pressure by means of the low vacuum pump 14 and, thereafter, helium is supplied to form a reduced pressure of helium ambience in the stage accommodating chamber 5, and the exposure is effected.

In this type of X-ray exposure apparatus, however, the amount of X-ray transmission from the blocking window 6 to the wafer 10 is greatly affected by a helium and impurity gas ambience within the stage accommodating chamber 5. If the purity of helium introduced into the stage accommodating chamber 5 is low, the amount of X-ray transmission decreases, which results in reduction in precision or a decrease in throughput, as of an exposure apparatus.

Further, if as in the above example a static pressure bearing means is present in the stage accommodating chamber 5, mere vacuum-evacuation of the stage accommodating chamber 5 and the subsequent replacement with good-purity helium does not assure the ability of maintaining the purity of helium within the stage accommodating chamber 5 for a long period of time, since there is an air leakage from the static pressure bearing means.

Additionally, it is necessary to retain the purity of helium at a high level. If it is desired to control the purity by using some purity detecting means, use of a very high precision detection and control means is required and to do so is practically difficult. Such an approach is described in EP-A-0178660.

An X-ray exposure apparatus in accordance with the present invention is defined in claim 1 of the claims appended.

It is an advantage of this apparatus that its construction is simple and can be of low cost, while adequate gas purity can be achieved and a high precision exposure can be performed.

Helium is preferred as the gas of X-ray absorbency lower than air and is considered below.

The quantity $G'_{He}$[Pa.m$^3$/$_S$] ($G_{He}$ [Torr $\ell$/S]) of supply of helium into the chamber preferably satisfies the following relationship:

$$G'_{He}/(G'_{He} + G'_{Air}) \geqq (1 - 11.65/P'd');$$

or

$$G_{He}/(G_{He} + G_{Air}) \geqq (1 - 8.74/Pd)$$

wherein

$G_{He}$ [Torr $\ell$/S] ...　　　the quantity of He supplied into
$G'_{He}$ [Pa m$^3$/$_S$]　　　　the chamber

$G_{Air}$ [Torr ℓ/S] ...            the quantity of air leaked into
$G'_{Air}$ [Pa m$^3$/$_S$]          the chamber
P [Torr] ...                the pressure in the
P'[Pa]                    chamber at the time of exposure
d [cm] ...                the distance to wafer from
d' [m]                    chamber window

Further, for replacement of the inside of the chamber with helium, it is preferable that the chamber is vacuum evacuated to a predetermined pressure at least not greater than 11.65/d' [Pa] (8.74/d [Torr]) and, thereafter, helium is supplied until the pressure in the chamber becomes equal to a pressure P'[Pa] (P [Torr]) to be established at the time of exposure.

Attention may be drawn to EP-A-0178660 which describes X-ray exposure apparatus comprising a windowed low-attenuation chamber containing He gas, with a supply source for the He gas and a gas inlet control valve.

## BRIEF DESCRIPTION OF THE DRAWINGS

Figure 1 is a schematic view of a bulb type X-ray exposure apparatus according to an embodiment of the present invention.

Figure 2 is a fragmentary view showing a static pressure bearing means for use in vacuum, which is adopted in the apparatus of the Figure 1 embodiment.

Figure 3 is a schematic view of a known type X-ray exposure apparatus.

## DESCRIPTION OF THE PREFERRED EMBODIMENTS

The invention will now be explained in greater detail.

If the X-ray transmission factor is denoted by Q, it can be expressed as follows:

$$Q = \exp[-\{\mu_{He}\rho_{He}(1\text{-}x) + \mu_{gas}\rho_{gas}\cdot x\}\cdot d]$$

In this equation, $\mu_{He}$ and $\mu_{gas}$ are the mass absorption coefficients of helium and impure gas, respectively; $\rho_{He}$ and $\rho_{gas}$ are the densities of the helium and the impure gas, respectively; x is the mole fraction of the impure gas; and d is the X-ray path length (the distance to the wafer from the blocking window), as described.

By using the above equation, an equation representing a change $\Delta Q$ in the X-ray transmission factor is given in the following manner:

$$\Delta Q = \partial Q/\partial \mu/\partial x \cdot \Delta x$$

$$\widetilde{} - \rho_0 (P'/101325)(100\ d')(M_{gas}/M_{He})\cdot\mu_{gas}\Delta x;\ \text{or}$$

$$\widetilde{} -\rho_0 (P/760)d(M_{gas}/M_{He})\mu_{gas}\Delta x$$

In this equation, $\rho_0$ is the density of helium at a unit pressure; P is the pressure in the stage accommodating chamber at the time of exposure as described; $M_{gas}$ is the molecular weight of the impure gas; and $M_{He}$ is the molecular weight of the helium.

As for the impure gas, there may be nitrogen ($N_2$), oxygen ($O_2$), air and the like. Here, consideration will be made of the oxygen which causes largest attenuation of X-rays.

Substituting numerical values into the above equation, it can be rewritten as follows:

$$\Delta Q = \text{-}3.43 \times 10^{-3} \times P' \times d' \times \Delta x;$$

or

$$\Delta Q = \text{-}4.58 \times 10^{-3} \times P \times d \times \Delta x$$

$$\Delta X = \text{-}(\Delta Q)/(3.43 \times 10^{-3} \times P' \times d');$$

or

$$\Delta X = \text{-}(\Delta Q)/(4.58 \times 10^{-3} \times P \times d)$$

Considering the purity of helium, since

Purity = 1 - (pressure of impure gas/pressure in stage accommodating chamber),

it follows that:

$$Purity = 1 - 2\bullet\Delta x$$

$$= 1 - 583 \times \Delta Q/(P' \times d'); \text{ or}$$

$$= 1 - 437 \times \Delta Q/(P \times d)$$

Assumingly, it is intended to suppress the X-ray illuminance change within a range of ±2% (as an example of practical value) in the whole exposure apparatus. If it is assumed that all the change of ±2% in the X-ray illuminance is caused by the change $\Delta Q$ in the X-ray transmission factor, it follows that:

$$Purity = 1\text{-}11.65/P'. \; d' \; (= 1 - 8.74/P.d)$$

Further, if, while taking into account the heat conduction and the mechanical strength of the beryllium window, the pressure P' (P) in the stage accommodating chamber is 20000 [Pa] (150 [Torr]) and the X-ray path d'(0.3 [m] (d is 30 [cm]), then it follows that:

$$Purity = 0.998$$

Accordingly, under the conditions described hereinbefore, the purity of helium at the time of exposure should be retained at a level not lower than 99.8 %.

Additionally, although in this example all the change of ±2 % in X-ray illuminance is treated as being caused only by the change in X-ray transmission factor, actually the change ±2 % should be treated dividedly in terms of several factors. Practically, it is preferable to treat one-tenth of ±2 % (i.e. ±0.2 %) as resulting from the change $\Delta Q$ in the X-ray transmission factor. In this case, the purity of helium at the time of exposure should be retained not lower than 99.98 %.

It will be understood from the foregoing that, under the described conditions, where the inside of the stage accommodating chamber is going to be replaced by helium, preferably the stage accommodating chamber is vacuum-evacuated to a predetermined pressure at least not greater than 11.65/d' [Pa](8.76/d[Torr]) and, thereafter, helium is supplied thereinto until the pressure in the stage accommodating chamber comes equal to the pressure P'[Pa] (P[Torr]) to be established at the time of exposure.

Further, it will be understood that the quantity $G'_{He}$ [Pa m$^3$/5]($G_{He}$ [Torr $\ell$/S]) of supply of helium into the stage accommodating chamber preferably satisfies the following relationship:

$$G'_{He}/G'_{He}+G'_{Air})\geqq(1\text{-}11.65/P'.d') \; G_{He}/(G_{He} +G_{Air})\geqq(1\text{-}8.74/P.d))$$

Pressure detecting and controlling means provided in the stage accommodating chamber may be used to maintain the pressure in the stage accommodating chamber constant. This is particularly convenient for continuously retaining the X-ray transmission factor at a level not less than a predetermined.

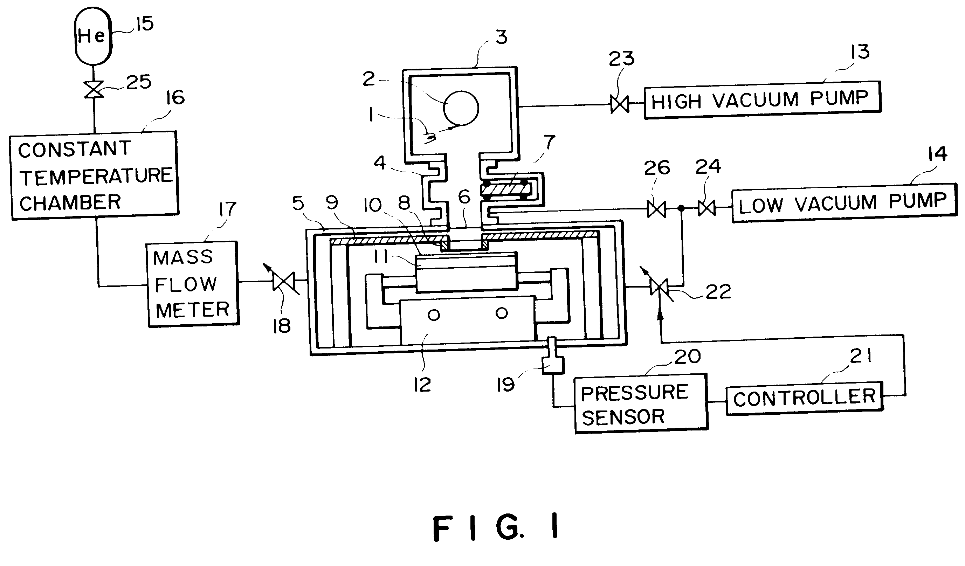

Referring now to Figure 1, there is shown the structure of a bulb type X-ray exposure apparatus according to an embodiment of the present invention. Figure 2 shows details of an in-vacuum static pressure bearing means used in the apparatus of Figure 1.

In Figure 1, an electron gun 1 and a target 2, constituting an X-ray source, are accommodated in an X-ray source accommodating chamber 3. Barrel 4 is coupled to the X-ray source accommodating chamber 3 and, to this barrel 4, a stage accommodating chamber 5 is coupled. The stage accommodating chamber 5 is equipped with a beryllium blocking window 6 through which X-rays produced at the target 2 can be projected to a mask 8 and then to a wafer 10. The barrel 4 is provided with a gate valve 7.

The stage accommodating chamber 5 accommodates therein a mask chuck 9, which is adapted to hold a mask 8 at an exposure station to be irradiated with the X-rays from the target 2, and a wafer chuck 11 which is adapted to hold, at the exposure station, a wafer 10 so that it is opposed to the mask 8, as well as a wafer stage 12 which is adapted to move the wafer chuck 11 along a plane which is substantially perpendicular to the direction of X-ray irradiation. The wafer stage 12 can be used for alignment of the wafer 10 with the mask 8. For guiding the wafer stage 12, an in-vacuum static pressure bearing means is used. Details of such static pressure bearing means will be described later, with reference to Figure 2.

To this X-ray accommodating chamber 3, a high vacuum pump 13 such as, for example, a turbo molecular pump or a diffusion pump is coupled by way of a valve 23. To the stage accommodating chamber 5 and the barrel 4, a low vacuum pump 14 such as an oil rotation pump, for example, is coupled by way of valves 22, 24 and 26. Of these valves, the valve 22 is provided at a piping which joins the stage accommodating chamber 5 with the low vacuum pump 14, and it is of a variable valve type wherein the degree of opening of the valve can be changed automatically. Pressure sensor 20 is adapted to detect the pressure in the stage accommodating chamber 5, in corporation with a detecting element 19 mounted to the stage accommodating chamber 5. On the basis of the result of this detection, controller 21 controls the degree of opening of the variable valve 22. By this, the pressure in the stage accommodating chamber 5 is controlled to be held continuously constant.

Helium gas is supplied from a helium tank 15 into the stage accommodating chamber 5, by way of a valve 25, a constant-temperature chamber 16 (whose temperature is maintained constant to make the temperature of the helium constant), a mass flow meter 17 and a valve 18, in the named order. The mass flow meter 17 is adapted to meter the quantity of supplied. helium, and the valve 18 is of a type wherein the degree of opening thereof can be adjusted manually.

Figure 2 shows details of an in-vacuum static pressure bearing means used for guiding the wafer stage 12.

In Figure 2, housing 30 is floated from an inside shaft 28, with a clearance of a few microns, by means of a high pressure air discharged toward the shaft 28 through a bushing 27 which is made of a porous material. At the opposite end portions, the housing 30 is provided with pockets 29a for sucking airs, each pocket being evacuated by means of a vacuum pump 31.

Referring to Figures 1 and 2, the sequence of operation of the X-ray exposure apparatus of the described structure will be explained. For convenience in explanation, it is assumed in this example that $\Delta Q = \pm 0.2$ %, P' = 20000 [Pa] (P = 150 [Torr]) and d' = 0.3 [m] (d = 30 [cm]). However, as a matter of course, the invention is not limited to these conditions.

First, the gate valve 7 is closed and, by means of the high vacuum pump 13, the X-ray source accommodating chamber is evacuated. On the other hand, while maintaining the by-pass valve 26 open, the stage accommodating chamber 5 is evacuated by the low vacuum pump 14 to a pressure not greater than 11.65 x (1/10)/d' = 11.65 x (1/10) /0.3 (8.74 x (1/10)/d = 8.74 x (1/10)/30) = 3.88 [Pa] (0.029 [Torr]). (It is to be noted here that the value "1/10" is used because one-tenth of the change $\pm 2$ % in the X-ray illuminance, i.e. $\pm 0.2$ %, is shared to the change in X-ray transmission factor.) Subsequently, the gate valve 7 is opened and the by-pass valve 26 is closed. The X-ray source accommodating chamber 3 is evacuated finally to a pressure not greater than $10^{-4}$ [Pa] ($10^{-6}$ [Torr]).

After this, helium of a purity 99.9999 % is supplied into the stage accommodating chamber 5 until the pressure therein comes equal to 20000 [Pa] (150 [Torr]), namely, until the pressure sensor 20 detects that the pressure in the stage accommodating chamber 5 comes equal to 20000 [Pa] (150 [Torr]). After this is attained, helium of a predetermined quantity (which will be described later) set in accordance with the quantity of air leakage into the chamber, is continuously supplied thereinto. On the other hand, by means of the controller 21 and the variable valve 22, any fluctuation in pressure within the stage accommodating chamber 5 is prevented, and the pressure in the chamber is maintained constantly at 20000 [Pa] (150) [Torr]. The quantity of supply of helium can be adjusted manually by the variable valve 18, in accordance with the quantity metered by the mass flow meter 17.

Next, the quantity of helium supply will be explained. A major part of the $G'_{Air}$ ($G_{Air}$) chamber 5 leakage of air into the stage accommodating chamber 5 is occupied by the leakage from the pockets (seals) 29a of the static pressure bearing means shown in Figure 2, and the remaining part can be disregarded. The clearance at the labyrinth 29b of the seal is of an order of a few microns and, therefore, there is a possibility that the leaked air is in the form of a molecular flow. Predicting a worst value, the quantity $G'_{Air}$ ($G_{Air}$) of the air leakage into the stage accommodating chamber 5 is taken as being diffused into the stage accommodating chamber by the partial pressure of the air, not by the full pressure in the stage accommodating chamber. Where the partial pressure of the air in the stage accommodating chamber 5 is denoted by $P'_{SAir}$ [Pa]($P_{SAir}$ [Torr]), the partial pressure of the air in the pocket 29a is denoted by $P'_{PAir}$ [Pa] ($P_{PAir}$ [Torr]), and the conductance at the labyrinth 29b which is at one side of the pocket closer to the stage accommodating chamber 5 is denoted by C' [$m^3/_S$] (C [$\ell/S$]) then:

$$G'_{Air} = C' \left(P'_{PAir} - P'_{SAir}\right) \left[Pa \; m^3/_S\right];$$

or

$$G_{Air} = C P_{PAir} - P_{SAir}) \left[Torr \; \ell/S\right]$$

$$\approx C'P'_{PAir} \left[Pa \; m^3/_S\right]; \; or$$

$$\approx C P_{PAir} \left[Torr \; \ell/S\right]$$

$$\left(\because P'_{SAir} \approx 0\right); \; or$$

$$\left(\because P_{SAir} \approx 0\right)$$

Where there are a plurality of pockets such as at 29a in Figure 2, the quantities of leakages from all the pockets total to the quantity $G'_{Air}$ ($G_{Air}$). For actual evaluation of a static pressure bearing means, the static pressure bearing means may be disposed within a test chamber and the pressure at the pocket may be checked. Further, the quantity $G'_{AIR}$ ($G_{Air}$) can be checked by detecting a difference in pressure attained in the stage accommodating chamber 5, between an occasion where the static pressure bearing means is introduced and an occasion where it is not introduced.

Once the quantity $G'_{Air}$ ($G_{Air}$) of air leakage from the labyrinth portion of the static pressure bearing means is evaluated on the basis of the calculation and experiment as described hereinbefore, the quantity $G_{He}$ of supply of helium can be determined, by means of the mass flow meter 17 and the manual valve 18, so as to satisfy the following relationship:

$$G'_{He}/(G'_{He} + G'_{Air}) \geq [1 - 11.65 \times (1/10)/20000X0.3]$$

$$= 0.9998; \text{ or}$$

$$G_{He}/(G_{He} + G_{Air}) \geq [1 - 8.74 \times (1/10)/(150 \times 30)]$$

$$= 0.9998$$

After this, exposure of the wafer 10 to the mask 8 with X-rays from the target 2, starts.

While in the foregoing embodiment description has been made under a condition that the change in helium ambience should be suppressed to not greater than ±0.2 %, as a matter of course the value is not limited to the described example but it may be determined on the basis of consideration of the part of the change ±2 % in X-ray illuminance to be shared to the change $\Delta Q$ in X-ray transmission factor. Also, while in the foregoing example an in-vacuum static pressure bearing means is examined in respect to the air leakage, if a similar sealing means is used at a portion of the stage accommodating chamber 5 from which a drive is introduced into the chamber, it is necessary to consider the leakage at such portion, too. Moreover, as a matter of course, the invention is not limited to one that uses a bulb type X-ray light source.

In accordance with the present invention, as described hereinbefore, a predetermined quantity of helium is continuously supplied into the stage accommodating chamber. As a result, it is possible to avoid deterioration in the purity of helium due to air leakage thereinto and, therefore, it is possible to prevent reduction in quantity of X-ray transmission. Further, for replacement of the inside of the stage accommodating chamber with helium, first the chamber is evacuated to a pressure at least not greater than 11.65/d'[Pa] (8.74/d [Torr]) and, thereafter, helium is introduced to provide a predetermined pressure and, after this, a predetermined quantity of helium is continuously supplied into the stage accommodating chamber while, by using a pressure detecting means and a controlling means provided in the stage accommodating chamber, the pressure in the chamber is maintained at a predetermined. As a result, only by a simple control of pressure, the helium ambience within the stage accommodating chamber can be stabilised and, as a consequence, it is possible to provide an X-ray exposure apparatus having an ability of performing high-precision exposure.

While in the foregoing description, helium is described as the low X-ray absorbency gas, it is to be understood that other gas of X-ray absorbency lower than air may be substituted.

While the invention has been described with reference to the structures disclosed herein, it is not confined to the details set forth and this application is intended to cover such modifications or changes as may come within the scope of the following claims.

## Claims

1.  An X-ray exposure apparatus for exposing a substrate (10) to X-rays, comprising:

    a windowed chamber (5,6) for containing a gas of X-ray absorbency less than that of air; and
    gas supply means (15, 16, 17, 18) for supplying gas to the chamber, the gas supplying means having an inlet valve (18) for controlling the flow of gas into the chamber;
    characterised in that:
    means (14,24) is provided for evacuating the chamber;
    pressure control means (19, 20, 21,22) is provided by which the pressure in the chamber is maintained at a pressure below atmosphere, wherein the pressure control means comprises a pressure sensor (19,20), and an outlet valve (22) for controlling the flow of gas out of the chamber; and
    the inlet valve (18) of the gas supply means is adapted to be set to supply continuously a predetermined quantity $G_{Gas}$[Pa m$^3$/s] of the gas to said chamber (5,6), which predetermined quantity $G_{Gas}$ of the gas satisfies a requirement that $G_{Gas}/(G_{Gas} + G_{Air})$ is not lower than a predetermined value, where $G_{Air}$ is the quantity of air leakage into said chamber (5, 6).

2.  An apparatus as claimed in claim 1, including mass flow meter (17) for measuring the quantity of supplied helium.

3.  An apparatus as claimed in claim 1 or claim 2, including supporting means (11) for supporting the substrate (10) at a distance d(m) from the window (6) of said chamber (5, 6), and wherein the following relationship can be satisfied:

$$G_{Gas}/(G_{Gas} + G_{Air}) > (1\text{-}11.65/Pd).$$

4. An apparatus as claimed in any preceding claim, wherein said gas supplying means (15, 16, 25) includes means (16) for supplying the gas at a maintained constant temperature.

5. An apparatus as claimed in any preceding claim, wherein said evacuating means (14, 24) comprises a vacuum pump (14) and a valve (24).

6. An apparatus as claimed in any preceding claim, including an X-ray source (1-2).

7. Use of the X-ray exposure apparatus as claimed in any preceding claim, wherein during X-ray exposure of the substrate (10):

> gas in said chamber (5, 6) is maintained at said reduced pressure P; and
> the gas of X-ray absorbency lower than air is supplied continuously in said predetermined quantity $G_{Gas}$.

8. A method of producing a semiconductor integrated circuit in which a fine pattern of the semiconductor integrated circuit is lithographically transferred from a mask (8) onto a semiconductor wafer substrate (10) by soft X-rays using, as claimed in claim 7, apparatus as claimed in any of claims 1 to 6.

**Patentansprüche**

1. Röntgenstrahl-Belichtungsvorrichtung zur Belichtung eines Substrats (10) mit Röntgenstrahlen mit:

> einer mit einem Fenster versehenen Kammer (5, 6), die ein Gas mit einem geringeren Röntgenstrahlen-Absorptionsvermögen als Luft enthält, und
> einer Gas-Zufuhreinrichtung (15, 16, 17, 18) zur Zufuhr von Gas in die Kammer, wobei die Gas-Zufuhreinrichtung ein Einlaßventil (18) zur Steuerung des Gasflusses in die Kammer aufweist,

**dadurch gekennzeichnet, daß**

> eine Einrichtung (14, 24) zur Evakuierung der Kammer vorgesehen ist,
> eine Druck-Regeleinrichtung (19, 20, 21, 22) vorgesehen ist, durch die der Druck in der Kammer auf einem Druck unter der Atmosphäre gehalten werden kann, wobei die Druck-Regeleinrichtung einen Drucksensor (19, 20) und ein Auslaßventil (22) zur Steuerung des Gasflusses aus der Kammer heraus aufweist, und
> das Einlaßventil (18) der Gas-Zufuhreinrichtung auf die ununterbrochene Zufuhr einer vorbestimmten Menge GGas [Pa m$^3$/s] des Gases in die Kammer (5, 6) eingestellt ist, wobei die vorbestimmte Menge GGas des Gases das Erfordernis erfüllt, daß $G_{Gas}/(G_{Gas} + G_{Air})$ nicht weniger als ein vorbestimmter Wert ist, wobei $G_{Air}$ die Menge von aufgrund eines Lecks in die Kammer (5, 6) eingedrungener Luft ist.

2. Vorrichtung nach Anspruch 1, gekennzeichnet durch eine Massenfluß-Meßeinrichtung (17) zur Messung der Menge von zugeführtem Helium.

3. Vorrichtung nach Anspruch 1 oder 2, gekennzeichnet durch eine Halteeinrichtung (11) zum Halten des Substrats (10) in einem Abstand d (m) von dem Fenster (6) der Kammer (5, 6), wobei die folgende Beziehung erfüllt sein kann:

$$G_{Gas}/(G_{Gas} + G_{Air}) > (1\text{-}11,65/Pd).$$

4. Vorrichtung nach einem der vorangehenden Ansprüche, dadurch gekennzeichnet, daß die Gas-Zufuhreinrichtung (15, 16, 25) eine Einrichtung (16) zur Zufuhr des Gases mit einer konstantgehaltenen Temperatur aufweist.

5. Vorrichtung nach einem der vorangehenden Ansprüche, dadurch gekennzeichnet, daß die Evakuierungseinrichtung (14, 24) eine Vakuumpumpe (14) und ein Ventil (24) aufweist.

6. Vorrichtung nach einem der vorangehenden Ansprüche, gekennzeichnet durch eine Röntgenstrahlenquelle (1-2).

7. Verwendung der Röntgenstrahl-Belichtungsvorrichtung nach einem der vorangehenden Ansprüche, wobei während der Röntgenstrahlen-Belichtung des Substrats (10)

   ein Gas in der Kammer (5, 6) auf dem verringertem Druck P gehalten wird und
   das Gas mit dem geringeren Röntgenstrahlen-Absorptionsvermögen als Luft ununterbrochen in der vorbestimmten Menge $G_{Gas}$ zugeführt wird.

8. Verfahren zur Herstellung einer integrierten Halbleiterschaltung, bei der ein feines Muster der integrierten Halbleiterschaltung lithographisch von einer Maske (8) auf ein Halbleiter-Wafersubstrat (10) durch weiche Röntgenstrahlen unter einer Verwendung nach Anspruch 7 oder einer Vorrichtung nach einem der Ansprüche 1 bis 6 übertragen wird.

## Revendications

1. Appareil d'exposition à des rayons X destiné à exposer un substrat (10) à des rayons X, comportant :

   une chambre (5, 6) à fenêtre destinée à contenir un gaz absorbant moins que l'air les rayons X ; et
   des moyens (15, 16, 17, 18) d'alimentation en gaz destinés à alimenter en gaz la chambre, les moyens d'alimentation en gaz ayant un robinet d'entrée (18) destiné à commander l'écoulement d'entrée de gaz dans la chambre ;

   caractérisé en ce que :

   des moyens (14, 24) sont prévus pour faire le vide dans la chambre ;
   des moyens (19, 20, 21, 22) de régulation de pression sont prévus, moyens par lesquels la pression dans la chambre est maintenue à une valeur inférieure à celle de l'atmosphère, les moyens de régulation de pression comportant un capteur (19, 20) de pression et un robinet (22) de sortie destiné à régler l'écoulement de gaz sortant de la chambre ; et
   le robinet d'entrée (18) des moyens d'alimentation en gaz est conçu pour être réglé afin d'alimenter en continu ladite chambre (5, 6), en une quantité prédéterminée $G_{Gaz}$[Pa m$^3$/s], laquelle quantité prédéterminée $G_{Gaz}$ de gaz satisfait l'exigence selon laquelle $G_{Gaz}/(G_{Gaz} + G_{Air})$ n'est pas inférieur à une valeur pédéterminée, où $G_{Air}$ est la quantité d'air pénétrant par fuite dans ladite chambre (5, 6).

2. Appareil selon la revendication 1, comprenant un débitmètre massique (17) destiné à mesurer la quantité d'hélium fournie.

3. Appareil selon la revendication 1 ou la revendication 2, comprenant des moyens (11) de support destinés à supporter le substrat (10) à une distance d(m) de la fenêtre (6) de ladite chambre (5, 6), et dans lequel la relation suivante peut être satisfaite :

$$G_{Gaz}/(G_{Gaz} + G_{Air}) > (1\text{-}11,65/Pd).$$

4. Appareil selon l'une quelconque des revendications précédentes, dans lequel lesdits moyens (15, 16, 25) d'alimentation en gaz comprennent des moyens (16) destinés à l'alimentation en gaz à une température maintenue constante.

5. Appareil selon l'une quelconque des revendications précédentes, dans lequel lesdits moyens (14, 24) destinés à faire le vide comprennent une pompe à vide (14) et un robinet (24).

6. Appareil selon l'une quelconque des revendications précédentes, comprenant une source (1-2) de rayons X.

7. Utilisation de l'appareil d'exposition aux rayons X selon l'une quelconque des revendications précédentes, dans laquelle, pendant une exposition du substrat (10) à des rayons X :

   le gaz dans ladite chambre (5, 6) est maintenu à ladite pression réduite P ; et

le gaz absorbant moins que l'air les rayons X est fourni en continu dans ladite quantité prédéterminée $G_{Gaz}$.

8. Procédé de production d'un circuit intégré de semiconducteurs dans lequel un motif fin du circuit intégré de semiconducteurs est reporté par lithographie d'un masque (8) sur un substrat (10) à tranche de semiconducteur par des rayons X mous en utilisant, selon la revendication 7, un appareil selon l'une quelconque des revendications 1 à 6.

FIG. I

F I G. 2

F I G. 3